# EUROPEAN PATENT APPLICATION

(11) **EP 3 723 455 A1**
(43) Date of publication of application: **14.10.2020**
(21) Application number: 18886231.2
(22) Date of filing: 06.12.2018
(51) Int. Cl.: H05B 33/10, H01L 51/44, H01L 51/50, H05B 33/04

(54) **ORGANIC ELECTRONIC DEVICE MANUFACTURING METHOD**

(30) Priority: 07.12.2017 JP 2017235455
(71) Applicant: Sumitomo Chemical Company Limited, Tokyo 104-8260 (JP)
(72) Inventor: SHIMOGAWARA Masaya, Niihama-shi Ehime 792-0015 (JP); MORISHIMA Shinichi, Tsukuba-shi Ibaraki 300-3294 (JP); KUROKI Hiroyoshi, Osaka-shi Osaka 559-8559 (JP); FUJIMOTO Eishi, Osaka-shi Osaka 559-8559 (JP); NAKASHIZU Yuta, Osaka-shi Osaka 559-8559 (JP)
(74) Representative: J A Kemp LLP
(86) International application number: PCT/JP2018/044952
(87) International publication number: WO 2019/112013

(57) **Abstract**

An organic electronic device manufacturing method according to one embodiment comprises: a device base forming step of forming a device base in which a first electrode, a device functional part including an organic layer, and a second electrode are provided in this order on a substrate; a dehydration step S22 of heating and dehydrating a protective film-equipped sealing member, in which a protective film is laminated, via an adhesive layer, on a sealing member having a sealing base, the adhesive layer laminated on an one surface of the sealing base, and a resin layer laminated on an other surface of the sealing base, while the protective film-equipped sealing member 10 is conveyed using at least one roll; and a sealing member bonding step of removing the protective film from the protective film-equipped sealing member after subjected to the dehydration step, and then bonding the sealing member to the device base through the adhesive layer, wherein in the dehydration step, a temperature of a roll surface of the roll R1 in contact with the protective film-equipped sealing member being conveyed is higher than or equal to a glass transition temperature of the resin layer.

## Description

### Technical Field

The present invention relates to an organic electronic device manufacturing method.

### Background Art

An organic electronic device includes a device base in which a first electrode, a device functional part (including an organic layer), and a second electrode are provided in this order on a substrate, and a sealing member that seals the device functional part. Examples of known sealing member include one disclosed in Patent Literature 1 in which a resin film is used as a support, and a barrier layer and an adhesive layer (resin composition layer) are laminated in this order on the support. Such a sealing member is bonded to a device base via an adhesive layer. In the technique described in Patent Literature 1, a protective film (cover film) is provided on the adhesive layer of the sealing member until the sealing member is bonded to the device base. Since the sealing member is used to prevent deterioration of the organic layer in the device functional part due to moisture, it is preferable that the sealing member itself be also dehydrated.

### Citation List

### Patent Literature

[Patent Literature 1] International Publication No. WO 2016/152756

### Summary of Invention

### Technical Problem

In Patent Literature 1, a protective film-equipped sealing member, which is a sealing member provided with a protective film, is heated and dehydrated using infrared rays. When the protective film-equipped sealing member is heated and dehydrated, the protective film-equipped sealing member tends to be heated at a temperature higher than or equal to the glass transition temperature of the resin film (resin layer) included in the sealing member. In this case, the molecular orientation of the resin film locally changes. Therefore, for example, when the protective film-equipped sealing member comes into contact with a conveyor roll and is rapidly cooled at the contact portion, creases are generated and fixed. As a result, creases also occur in the sealing member, so that when the sealing member is bonded to the device base, a desired sealing performance may not be secured because bubbles are mixed in the bonding surface and sufficient bonding cannot be achieved due to the creases in the bonding surface.

For this reason, an object of the present invention is to provide an organic electronic device manufacturing method that can provide an organic electronic device with desired sealing performance.

### Solution to Problem

An organic electronic device manufacturing method according to one aspect of the present invention comprises: a device base forming step of forming a device base in which a first electrode, a device functional part including an organic layer, and a second electrode are provided in this order on a substrate; a dehydration step of heating and dehydrating a protective film-equipped sealing member, in which a protective film is laminated, via an adhesive layer, on a sealing member having a sealing base, the adhesive layer laminated on an one surface of the sealing base, and a resin layer laminated on an other surface of the sealing base, while the protective film-equipped sealing member is conveyed using at least one roll; and a sealing member bonding step of removing the protective film from the protective film-equipped sealing member subjected to the dehydration step, and then bonding the sealing member to the device base through the adhesive layer, wherein in the dehydration step, a temperature of a roll surface of the roll in contact with the protective film-equipped sealing member being conveyed is higher than or equal to a glass transition temperature of the resin layer.

In the aforementioned manufacturing method, in the dehydration step, the temperature of a roll surface of the roll in contact with the protective film-equipped sealing member is higher than or equal to a glass transition temperature of the resin layer. Accordingly, in the dehydration step, even if the heated protective film-equipped sealing member comes into contact with the roll, it is not rapidly cooled. As a result, occurrence and fixation of creases in the protective film-equipped sealing member in the dehydration step are suppressed.

The organic electronic device manufacturing method according to one embodiment may comprise a slow cooling step of, after the dehydration step, slowly cooling the protective film-equipped sealing member until the protective film-equipped sealing member becomes below a glass transition temperature of the resin layer. Hence, occurrence of creases in the protective film-equipped sealing member after the dehydration step can also be suppressed.

In the slow cooling step, the protective film-equipped sealing member may be conveyed with a plurality of rolls; and a temperature of a roll surface of each of the plurality of rolls in the slow cooling step may be set in such a way as to gradually decrease from a temperature higher than or equal to the glass transition temperature of the resin layer to a temperature lower than the glass transition temperature of the resin layer, from an upstream roll to a downstream roll. Hence, even in the slow cooling step, the protective film-equipped sealing member is not rapidly cooled by contact with the plurality of rolls, which can suppress occurrence of creases.

The organic electronic device manufacturing method according to one embodiment may comprise a preheating step of, before the dehydration step, gradually heating the protective film-equipped sealing member until the protective film-equipped sealing member becomes higher than or equal to a glass transition temperature of the resin layer. In the preheating step, the protective film-equipped sealing member may be conveyed with a plurality of preheating rolls; and a temperature of a roll surface of each of the plurality of preheating rolls in the preheating step may be set in such a way as to gradually increase from a temperature lower than the glass transition temperature of the resin layer to a temperature higher than or equal to the glass transition temperature of the resin layer, from an upstream preheating roll to a downstream preheating roll.

### Advantageous Effects of Invention

The present invention can provide an organic electronic device manufacturing method that can provide an organic electronic device with desired sealing performance.

### Brief Description of Drawings

[Figure 1] Figure 1 is a side view of a protective film-equipped sealing member according to one embodiment.
[Figure 2] Figure 2 is a flowchart showing a method of manufacturing an organic EL device (organic electronic device) using the protective film-equipped sealing member shown in Figure 1.
[Figure 3] Figure 3 is a cross-sectional view showing an example of the configuration of a device base included in an organic EL device to be manufactured.
[Figure 4] Figure 4 is a drawing for explaining the preparation step shown in Figure 2.
[Figure 5] Figure 5 is a drawing for explaining a sealing member bonding step in a method of manufacturing an organic EL device (organic electronic device).

### Description of Embodiments

An embodiment of the present invention will now be described with reference to drawings. The same elements are denoted by the same reference numerals, and the same description will be omitted. The dimensional ratios in the drawings do not always match those described.

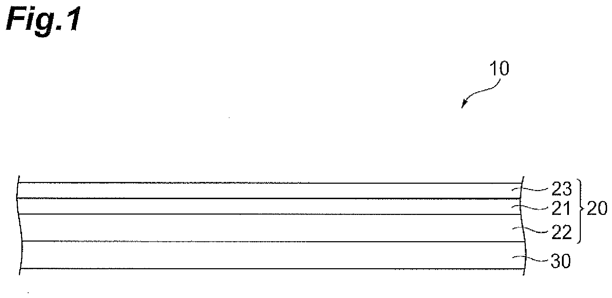

Figure 1 is a side view of a protective film-equipped sealing member 10 used for manufacturing an organic EL device (organic electronic device) according to one embodiment. Figure 1 schematically shows the configuration of the protective film-equipped sealing member 10. The protective film-equipped sealing member 10 includes a sealing member 20 and a protective film 30. The protective film-equipped sealing member 10 may have a strip shape or cut sheet shape. Unless otherwise specified, the protective film-equipped sealing member 10 has a strip shape in the following description.

The sealing member 20 is a member for preventing the organic layer included in the organic EL device from being deteriorated. The sealing member 20 has a sealing base 21, an adhesive layer 22, and a resin film (resin layer) 23.

The sealing base 21 has a moisture barrier function. An example of the moisture permeability of the sealing base 21 is 5×10⁻⁵ g/(m²●24hr) or less under an environment at a temperature of 40°C and a humidity of 90 %RH. The water vapor transmission rate can be measured, for example, by the calcium corrosion method. The sealing base 21 may have a gas barrier function. Examples of the sealing base 21 include a metal foil, a barrier film having a barrier function layer on one or both sides of a transparent plastic film, or a thin film glass having flexibility, or a film in which a metal having barrier properties is laminated on a plastic film. An example of the thickness of the sealing base 21 is in the range of 10 µm to 300 µm. The metal foil is preferably a copper foil, an aluminum foil, or a stainless steel foil from the viewpoint of barrier properties. When the sealing base 21 is a metal foil, it is preferable that the thickness of the metal foil be as large as possible from the viewpoint of suppressing pinholes, and be in the range of 10 µm to 50 µm in consideration of flexibility.

The adhesive layer 22 is laminated on one surface of the sealing base 21. The adhesive layer 22 is a layer provided to bond at least two adjacent layers to each other. The adhesive layer 22 has a thickness with which a portion to be sealed by the sealing member 20 in the organic EL device can be buried. An example of the thickness of the adhesive layer 22 is in the range of 5 µm to 100 µm.

Examples of material for the adhesive layer 22 include a photocurable or thermosetting acrylate resin, and a photocurable or thermosetting epoxy resin. Other examples that can be used as the adhesive layer 22 include resin films that can be fused with a generally used impulse sealer, for example, heat-fusible films such as an ethylene vinyl acetate copolymer (EVA), polypropylene (PP) films, polyethylene (PE) films, and polybutadiene films. A thermoplastic resin can also be used as a material for the adhesive layer 22. Examples of the thermoplastic resin include olefin-based elastomers, styrene-based elastomers, and butadiene-based elastomers.

The adhesive layer 22 may include a moisture absorbent. The moisture absorbent is an agent that absorbs moisture. The moisture absorbent may absorb oxygen and the like in addition to moisture. It is preferable that the moisture absorption rate of the moisture absorbent be 1 wt%/hr or more in an environment where the temperature is 24°C and the humidity is 55 %RH.

The resin film 23 is laminated on the other surface of the sealing base 21 (the surface opposite to the surface in contact with the adhesive layer 22). The resin film 23 can function as a support for the sealing base 21. Examples of material for the resin film 23 include polyethylene terephthalate (PET) and polyimide (PI).

The protective film 30 is laminated on the surface of the adhesive layer 22 opposite to the surface in contact with the sealing base 21. In other words, the protective film 30 is laminated on the sealing member 20 via the adhesive layer 22. The protective film 30 is a member for preventing dust from adhering to the adhesive layer 22 and preventing the adhesive layer 22 from adhering to a plurality of conveyor rolls R, which will be described later, before the organic EL device is manufactured. The protective film 30 may be a release film that can be released from the adhesive layer 22.

Examples of material for the protective film 30 include polyethylene naphthalate (PEN), PET, PP, PE, PI, cycloolefin polymer, and cycloolefin copolymer. Examples of the thickness of the protective film 30 include the range of 9 µm to 50 µm.

A coating layer may be formed on the surface of the protective film 30 that is in contact with the adhesive layer 22. Examples of material for the coating layer include silicone resin-based release agents, fluorine-based release agents, alkyd-based release agents, and acrylic-based release agents.

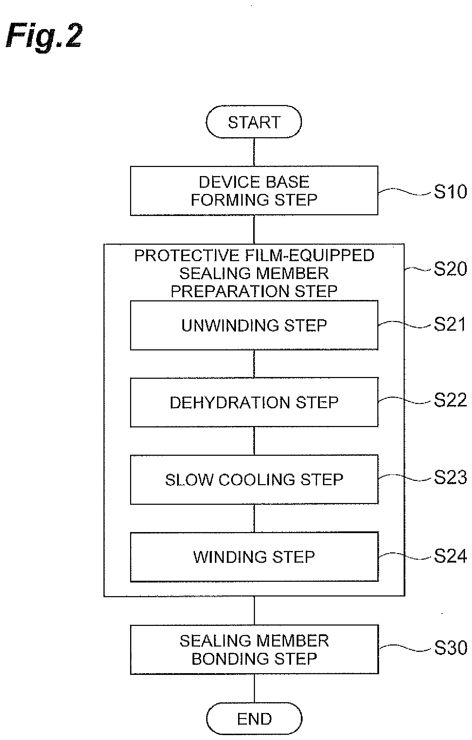

An example of a method for manufacturing an organic EL device using the protective film-equipped sealing member 10 shown in Figure 1 will now be described. As shown in Figure 2, the method for manufacturing an organic EL device includes a device base forming step S10, a protective film-equipped sealing member 10 preparation step S20, and a sealing member bonding step S30. Unless otherwise specified, although the case where the organic EL device to be manufactured is of a bottom emission type will be described, the organic EL device may be of a top emission type.

### [Device Base Forming Step]

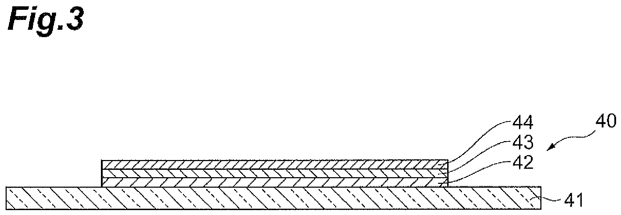

In the device base forming step S10, as shown in Figure 3, an anode (first electrode) 42, an organic EL unit (device functional part including an organic layer) 43, and a cathode (second electrode) 44 are stacked in this order on the substrate 41, thereby forming the device base 40. The device base 40 will now be described.

### [Substrate]

The substrate 41 transmits light (including visible light having a wavelength of 400 nm to 800 nm) emitted from the organic EL device to be manufactured. In this embodiment, the substrate 41 used to manufacture the organic EL device has a strip shape. An example of the thickness of the substrate 41 is in the range of 30 µm to 700 µm.

It is preferable that the substrate 41 be a flexible substrate. The flexibility is a property that allows the substrate to bend without being sheared or broken even when a predetermined force is applied to the substrate. An example of the substrate 41 is a plastic film or a polymer film. The substrate 41 may further include a barrier layer having a moisture barrier function. The barrier layer may have a function of blocking a gas (for example, oxygen) in addition to a function of blocking moisture.

### [Anode]

The anode 42 is provided on the substrate 41. A light transmissive electrode is used as the anode 42. As the light transmissive electrode, a thin film containing a metal oxide, a metal sulfide, a metal, and the like having high electric conductivity can be used, and a thin film having high light transmittance is preferably used. The anode 42 may have a network structure of a conductor (for example, a metal). The thickness of the anode 42 can be determined in consideration of light transmittance, electric conductivity, and the like. The thickness of the anode 42 is usually in the range of 10 nm to 10 µm, preferably 20 nm to 1 µm, and more preferably 50 nm to 500 nm.

Examples of material for the anode 42 include indium oxide, zinc oxide, tin oxide, indium tin oxide (Indium Tin Oxide which is abbreviated as ITO), indium zinc oxide (Indium Zinc Oxide which is abbreviated IZO), gold, platinum, silver, and copper, and of these, ITO, IZO or tin oxide is preferable. The anode 42 can be formed as a thin film containing the exemplified materials. Examples of material for the anode 42 include organic substances such as polyaniline and the derivative thereof, and polythiophene and the derivative thereof may be used. In this case, the anode 42 can be formed as a transparent conductive film.

The anode 42 can be formed by a dry film forming method, a plating method, a coating method, or the like. Examples of the dry film forming method include the vacuum deposition method, sputtering method, ion plating method, and CVD method. Examples of the coating method include the inkjet printing method, slit coating method, microgravure coating method, gravure coating method, bar coating method, roll coating method, wire bar coating method, spray coating method, screen printing method, flexographic printing method, offset printing method, and nozzle printing method, and of these, the ink jet printing method is preferable.

### [Organic EL unit]

The organic EL unit 43 is a functional part that contributes to light emission of the organic EL device, such as movement of charges and recombination of charges, according to the voltage applied to the anode 42 and the cathode 44. The organic EL unit 43 has an organic layer such as a light emitting layer.

The light emitting layer is a functional layer having a function of emitting light (including visible light). The light emitting layer is generally composed of an organic substance that mainly emits at least fluorescence or phosphorescence, or of this organic substance and a dopant material that helps the organic substance. Accordingly, the light emitting layer is an organic layer (a layer containing an organic substance). The dopant material is added, for example, to improve the luminous efficiency or change the luminous wavelength. The organic substance may be a low molecular compound or a high molecular compound. The thickness of the light emitting layer is, for example, about 2 nm to 200 nm.

Examples of the organic substance that mainly emits at least fluorescence or phosphorescence include the following dye-based materials, metal complex-based materials, and polymer-based materials.

### (Dye-Based Material)

Examples of the dye-based material include cyclopendamine derivatives, tetraphenylbutadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, oxadiazole dimer, pyrazoline dimer, quinacridone derivatives, and coumarin derivatives.

### (Metal Complex-Based Material)

Examples of the metal complex-based material include metal complexes containing a rare earth metal such as Tb, Eu, and Dy, or Al, Zn, Be, Ir, Pt, or the like as a central metal, and having oxadiazole, thiadiazole, phenylpyridine, phenylbenzimidazole, or quinoline as a ligand; for example, metal complexes, such as iridium complexes and platinum complexes, having light emission from a triplet excited state, aluminum quinolinol complexes, benzoquinolinol beryllium complexes, benzooxazolyl zinc complexes, benzothiazole zinc complexes, azomethyl zinc complexes, porphyrin zinc complexes, and phenanthroline europium complexes.

### (High Molecular-Based Material)

Examples of high molecular-based materials include polyparaphenylene vinylene derivatives, polythiophene derivatives, polyparaphenylene derivatives, polysilane derivatives, polyacetylene derivatives, polyfluorene derivatives, polyvinyl carbazole derivatives, and materials obtained by polymerizing the aforementioned dye-based materials or metal complex-based light-emitting materials.

### (Dopant Material)

Examples of the dopant material include perylene derivatives, coumarin derivatives, rubrene derivatives, quinacridone derivatives, squarylium derivatives, porphyrin derivatives, styryl dyes, tetracene derivatives, pyrazolone derivatives, decacyclene, and phenoxazone.

The light emitting layer can be formed by a dry film forming method, a coating method, or the like. Examples of the dry film forming method and coating method are similar to the case of the anode 42. The light emitting layer is preferably formed by the inkjet printing method.

The organic EL unit 43 may have various functional layers other than the light emitting layer. Examples of the functional layer disposed between the anode 42 and the light emitting layer include a hole injection layer and a hole transport layer. Examples of the functional layer disposed between the cathode 44 and the light emitting layer include an electron injection layer and an electron transport layer. The electron injection layer may be a part of the cathode 44. The hole injection layer is a functional layer having a function of improving the efficiency of hole injection from the anode 42 to the light emitting layer. The hole transport layer is a functional layer having a function of improving the efficiency of hole injection from the anode 42, the hole injection layer, or a portion of the hole transport layer closer to the anode 42 to the light emitting layer. The electron transport layer is a functional layer having a function of improving the efficiency of electron injection from the cathode 44, the electron injection layer, or a portion of the electron transport layer closer to the cathode 44 to the light emitting layer. The electron injection layer is a functional layer having a function of improving the efficiency of electron injection from the cathode 44 to the light emitting layer.

An example of the layer configuration of the organic EL unit 43 is shown below. In the following example of the layer configuration, the anode and the cathode are also noted in brackets in order to show the positional relationship between the anode 42 and the cathode 44 and the various functional layers.
(a) (anode)/light emitting layer/(cathode)
(b) (anode)/hole injection layer/light emitting layer/(cathode)
(c) (anode)/hole injection layer/light emitting layer/electron injection layer/(cathode)
(d) (anode)/hole injection layer/light emitting layer/electron transport layer/electron injection layer/(cathode)
(e) (anode)/hole injection layer/hole transport layer/light emitting layer/(cathode)
(f) (anode)/hole injection layer/hole transport layer/light emitting layer/electron injection layer/(cathode)
(g) (anode)/hole injection layer/hole transport layer/light emitting layer/electron transport layer/electron injection layer/(cathode)
(h) (anode)/light emitting layer/electron injection layer/(cathode)
(i) (anode)/light emitting layer/electron transport layer/electron injection layer/(cathode)

The symbol "/" means that the layers on both sides of the symbol "/" are joined.

A known material can be used as a material for a functional layer (for example, a hole injection layer, a hole transport layer, an electron injection layer, or an electron transport layer) other than the light emitting layer of the organic EL unit 43. These functional layers may be organic layers containing an organic substance. The optimum value of the thickness of the functional layer of the organic EL unit 43 differs depending on the material used. The thickness of the functional layer is set in consideration of electric conductivity, durability, and the like. Functional layers other than the light emitting layer of the organic EL unit 43 can be formed in the same manner as the light emitting layer.

### [Cathode]

The cathode 44 is provided on the organic EL unit 43. The optimum value of the thickness of the cathode 44 differs depending on the material used. The thickness of the cathode 44 is set in consideration of electric conductivity, durability, and the like. The thickness of the cathode 44 is usually in the range of 10 nm to 10 µm, preferably 20 nm to 1 µm, and more preferably 50 nm to 500 nm.

It is preferable that the material for the cathode 44 be a material having a high reflectance of light (particularly, visible light) from the light emitting layer of the organic EL unit 43 so that the light from the organic EL unit 43 (specifically, the light from the light emitting layer) is reflected by the cathode 44 and travels toward the anode 42. Examples of material for the cathode 44 include alkali metals, alkaline earth metals, transition metals, and metals of Group 13 of the periodic table. A transparent conductive electrode containing, for example, a conductive metal oxide and a conductive organic substance may be used as the cathode 44.

Examples of method for forming the cathode 44 include a coating method such as an ink-jet method, a slit coater method, a gravure printing method, a screen printing method or a spray coater method, a vacuum deposition method, a sputtering method, and a lamination method for thermocompression of a metal thin film.

In the device base forming step S10, the anode 42, the organic EL unit 43, and the cathode 44 are stacked in this order on a plurality of device forming regions virtually set on the substrate 41, respectively, while conveying the strip-shaped substrate 41 with a roll-to-roll system in the longitudinal direction, thereby forming a device base 40. The anode 42, the organic EL unit 43, and the cathode 44 can be formed by the method described above. When the organic EL unit 43 has a multilayer structure, the layers may be formed in the order from the anode 42 side.

### [Step of Preparing Protective Film-Equipped Sealing Member]

In the step S20 of preparing a protective film-equipped sealing member (hereinafter referred to as preparation step S20), the protective film-equipped sealing member 10 is heated and dehydrated with a roll-to-roll system. As shown in Figure 2, the preparation step S20 includes an unwinding step S21, a dehydration step S22, a slow cooling step S23, and a winding step S24. In this embodiment, a mode in which the slow cooling step S23 is provided between the dehydration step S22 and the winding step S24 will be described. However, the preparation step S20 does not necessarily include the slow cooling step S23.

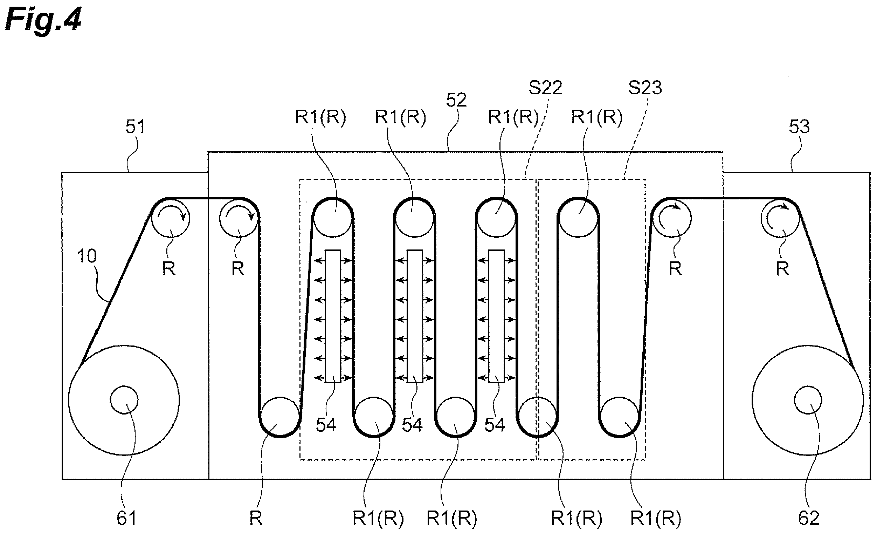

Figure 4 is a diagram for explaining the protective film-equipped sealing member preparation step S20. In Figure 4, the protective film-equipped sealing member 10 is schematically indicated by the thick solid line, and for convenience of explanation, regions related to the dehydration step S22 and the slow cooling step S23 are indicated by the dashed lines. In the preparation step S20, the protective film-equipped sealing member 10 is heated and dehydrated while being conveyed in the longitudinal direction with a plurality of conveyor rolls R. During conveyance of the protective film-equipped sealing member 10, a constant tension (for example, 30 N) is applied in the longitudinal direction. In this embodiment, the protective film-equipped sealing member 10 is conveyed so that the protective film 30 is in contact with the conveyor rolls R, but the resin film 23 may be in contact with the conveyor rolls R.

### (Unwinding Step)

In the unwinding step S21, as shown in Figure 4, the roll-like protective film-equipped sealing member 10 is set in an unwinding portion 61 disposed in an unwinding chamber 51, and the protective film-equipped sealing member 10 is then unwound. The unwound protective film-equipped sealing member 10 is conveyed to a heating chamber 52 with the conveyor roll R. The unwinding chamber 51 and the heating chamber 52 may be directly connected as shown in Figure 4 or may be connected through a joint.

### (Dehydration Step)

In the dehydration step S22, the protective film-equipped sealing member 10 conveyed from the unwinding chamber 51 is heated and dehydrated using infrared rays while being conveyed with the conveyor roll R. To be specific, the protective film-equipped sealing member 10 is irradiated with infrared rays from an infrared irradiator 54 disposed on the conveyance path of the protective film-equipped sealing member 10 to heat and dehydrate the protective film-equipped sealing member 10.

The infrared irradiator 54 has a configuration with which infrared rays used for heating and dehydration can be output, and is, for example, an infrared heater. The infrared irradiator 54 may be positioned with respect to the protective film-equipped sealing member 10, for example, so that the protective film-equipped sealing member 10 can be irradiated with infrared rays from the protective film 30 side.

It is preferable that the infrared rays applied to the protective film-equipped sealing member 10 be near/middle infrared rays (having a wavelength of 1.8 µm to 3.0 µm) including a water absorption wavelength in order to efficiently heat and dehydrate the protective film-equipped sealing member 10.

Each of the plurality of conveyor rolls R used in the dehydration step S22 is a heating roll (roll) R1. The temperature of the roll surface of the heating roll R1 (that is, the heating roll R1 in contact with the protective film-equipped sealing member 10 heated with infrared rays from the infrared irradiator 54) is set higher than or equal to the glass transition temperature of the resin film 23. The temperature of the roll surface of the plurality of heating rolls R1 may be set to substantially the same temperature, or may be different as long as it is higher than or equal to the glass transition temperature of the resin film 23. The configuration of the heating roll R1 is not limited as long as the temperature of the roll surface can be set to the aforementioned temperature. For example, the heating roll R1 may be configured so that a liquid (for example, water or oil) having a temperature at which the temperature of the roll surface can be set higher than or equal to the glass transition temperature flows along the axis of the heating roll R1 or the heater may be built in the heating roll R1. In this embodiment, a mode in which a plurality of heating rolls R1 are used in the dehydration step S22 is described; alternatively, one heating roll R1 may be used in the dehydration step S22.

### (Slow Cooling Step)

The slow cooling step S23 is performed in the heating chamber 52 subsequently to the dehydration step S22. In the slow cooling step S23, the protective film-equipped sealing member 10 is cooled slowly to a temperature lower than the glass transition temperature of the resin film 23 while the protective film-equipped sealing member 10 is conveyed with the plurality of conveyor rolls R in the heating chamber 52. The plurality of conveyor rolls R in contact with the protective film-equipped sealing member 10 during the slow cooling step S23 are also heating rolls R1, and the temperature of the roll surface of the plurality of heating rolls R1 may be set so that it gradually decreases from a temperature higher than or equal to the glass transition temperature of the resin film 23 to a temperature below the glass transition temperature, from the upstream heating roll R1 toward the downstream heating roll R1. Thus, changing the temperature of the roll surface of the plurality of heating rolls R1 may slowly cool the protective film-equipped sealing member 10. In the plurality of heating rolls R1 to be gradually lowered, the temperature of the roll surface of each heating roll R1 may be set according to, for example, the conveyance distance, the conveyance speed, and the like in the slow cooling step S23. For example, when the conveyance distance in the slow cooling step S23 is long, the difference between the roll surface temperatures of the heating rolls R1 adjacent to each other in the conveyance direction of the protective film-equipped sealing member 10 is set large, and at a high conveyance speed, the difference between the roll surface temperatures of the heating rolls R1 adjacent to each other in the conveyance direction of the protective film-equipped sealing member 10 may be set small. The conveyance distance in the slow cooling step S23 is a distance at which the temperature of the resin film 23 become lower than the glass transition temperature, and may be calculated in advance by a simulation or may be a distance based on an actual experimental result.

In the slow cooling step S23, for example, preheating may be performed at a temperature lower than in the dehydration step S22, using the infrared irradiator 54 so that the temperature gradually decreases toward the downstream side; for example, hot wind may be supplied.

In this embodiment, through the slow cooling step S23, after the temperature of the resin film 23 becomes lower than the glass transition temperature, the protective film-equipped sealing member 10 is conveyed in contact with the conveyor roll R having a roll surface temperature lower than the glass transition temperature. It is preferable that the temperature of the roll surface of the conveyor roll R be room temperature (for example, in the range of 22°C to 30°C).

### (Winding Step)

In the winding step S24, the protective film-equipped sealing member 10 that has been heated and dehydrated in the heating chamber 52 is wound into a roll shape in the winding unit 62 in a winding chamber 53 provided in a stage subsequent to the heating chamber 52. In the winding chamber 53, the protective film-equipped sealing member 10 conveyed from the heating chamber 52 is conveyed with the conveyor roll R toward the winding unit 62. As shown in Figure 4, the heating chamber 52 and the winding chamber 53 may be connected directly or via a joint.

### [Sealing Member Bonding Step]

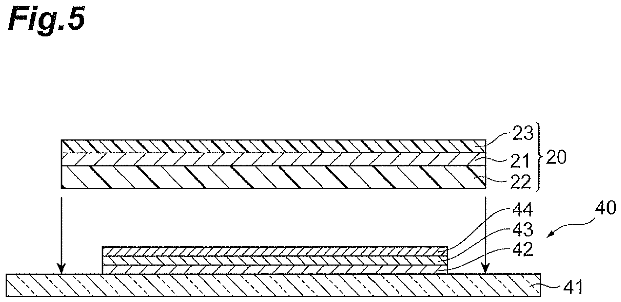

In the sealing member bonding step S30, the protective film 30 is removed from the protective film-equipped sealing member 10 that has been subjected to the dehydration step S22, and as shown in Figure 5, the sealing member 20 is bonded to the device base 40 via the adhesive layer 22, thereby yielding an organic EL device. The sealing member bonding step S30 can be performed by the roll-to-roll system while conveying the protective film-equipped sealing member 10 and the device base 40 in the longitudinal direction.

To be specific, the heated and dehydrated roll-like protective film-equipped sealing member 10 is set in the unwinding unit disposed in the unwinding chamber for the protective film-equipped sealing member 10 for the sealing member bonding step S30. Afterwards, the protective film-equipped sealing member 10 is unwound and the protective film 30 is continuously removed from the protective film-equipped sealing member 10 while being conveyed in the longitudinal direction.

Next, while being conveyed in the longitudinal direction, the sealing member 20 obtained by removing the protective film 30 from the protective film-equipped sealing member 10 is continuously bonded to the device base 40 being conveyed in the longitudinal direction. To be specific, with the adhesive layer 22 of the sealing member 20 facing the device base 40 as shown in Figure 5, the sealing member 20 and the device base 40 are pressurized and heated in the thickness direction to bond the sealing member 20 to the device base 40.

The device base 40 being conveyed in the longitudinal direction may be the device base 40 that has been continuously conveyed subsequently after forming the cathode 44 in the device base forming step S10, or may be the device base 40 that has been unwound after setting the device base 40, once rolled up after forming the cathode 44, at an unwinding unit for the device base 40.

Although the device base 40 is simplified and schematically depicted in Figures 3 and 5, the anode 42 and the cathode 44 may each be configured such that a part of each of the anode 42 and the cathode 44 can be drawn from the sealing member 20 so as to be able to apply voltage to the anode 42 and the cathode 44. Alternatively, the anode 42 and the cathode 44 may be formed to electrically connect to corresponding electrode parts by forming, on the substrate 41, the electrode parts disposed corresponding to the respective anode 42 and cathode 44, portions of the electrode parts being arranged outside the sealing member 20.

Through the sealing member bonding step S30, an organic EL device is formed for each device formation region virtually set on the substrate 41. For this reason, the organic EL device manufacturing method may include an individualization step of making the substrate 41 that has been subjected to the sealing member bonding step S30 into an individual piece per device formation region. In the individualization step, the substrate 41 is split per device formation region to obtain organic EL devices with product size.

The organic EL device manufacturing method includes the dehydration step S22, so that moisture is removed from the sealing member 20 and the sealing member 20 can be bonded to the device base 40. Consequently, excellent sealing performance can be achieved, and the deterioration of the organic layer in the organic EL device due to moisture can be suppressed.

In the dehydration step S22, the moisture in the protective film-equipped sealing member 10 is directly heated using infrared rays, so that the dehydration step S22 can be efficiently performed. Moreover, use of infrared rays makes it easier to perform the dehydration step S22 while conveying the protective film-equipped sealing member 10. Accordingly, the time required for the dehydration step S22 can be shortened, which enhances the productivity of the organic EL device.

In the dehydration step S22, the protective film-equipped sealing member 10 tends to be heated to a temperature higher than or equal to the glass transition temperature of the resin film 23. In this case, a local change in molecular orientation occurs in the resin film 23. When the resin film 23 is rapidly cooled in this state, creases continuously extending in the conveyance direction occur and the creases are fixed and become apparent. In the heating chamber 52, the plurality of conveyor rolls R are usually arranged in such a way as to convey the protective film-equipped sealing member 10 along a designed conveyance path. However, the protective film-equipped sealing member 10 may slightly meander due to an error in installing the conveyor rolls R. When such meandering occurs, the state of contact of the protective film-equipped sealing member 10 with the conveyor roll R in the width direction (the direction orthogonal to the longitudinal direction) becomes uneven, and creases are likely to become more apparent. When creases occur in the resin film 23, creases also occur in the sealing base 21 accordingly. As a result, a sealing member with creases is bonded to the device base, so that a desired sealing performance is not always secured because bubbles are mixed in the bonding surface or sufficient bonding cannot be achieved due to the creases.

In contrast, in the dehydration step S22 of the manufacturing method, the protective film-equipped sealing member 10 is conveyed using the heating roll R1 in which the temperature of the roll surface is set higher than or equal to the glass transition temperature of the resin film 23. Accordingly, the temperature of the resin film 23 is not rapidly cooled even if the heated protective film-equipped sealing member 10 is in contact with the heating roll R1, so that the occurrence and fixation of the creases can be suppressed. As a result, the sealing member 20 having a desired shape with suppressed creases can be bonded to the device base 40, and an organic EL device having good sealing performance can be manufactured.

The manufacturing method described in this embodiment includes the slow cooling step S23 after the dehydration step S22. In the slow cooling step S23, the protective film-equipped sealing member 10 heated in the dehydration step S22 is slowly cooled, so that the occurrence and fixation of the creases can be suppressed also during the period from the dehydration step S22 to the winding step S24. In the embodiment in which the conveyor rolls R in the slow cooling step S23 are heating rolls R1, rapid cooling due to the contact of the protective film-equipped sealing member 10 with the heating rolls R1 does not occur even during the slow cooling step S23, so that the occurrence and fixation of the creases can be suppressed.

The effects of using the heating rolls R1 will be further described below with reference to examples and comparative examples.

### [Example 1]

In Example 1, a long protective film-equipped sealing member A in which a protective film (thickness: 12 µm), an adhesive layer (thickness: 30 µm), an aluminum foil (thickness: 30 µm), and a PET film (thickness: 38 µm) are laminated in this order was prepared. The width of the protective film-equipped sealing member A was 300 mm. In the protective film-equipped sealing member A, the adhesive layer, the aluminum foil, and the PET film correspond to the adhesive layer 22, the sealing base 21, and the resin film 23 shown in Figure 1. For this reason, a member obtained by removing the protective film from the protective film-equipped sealing member A is referred to as a sealing member. The glass transition temperature of PET, a material of the PET film, was 69°C.

A dehydration step was performed in such a manner that the prepared protective film-equipped sealing member A was heated to 130°C with an infrared heater while being conveyed in the heating chamber at a tension of 30 N. During the dehydration step, the conveyor roll in contact with the protective film-equipped sealing member A was heating roll, and the roll surface was heated to 80°C with hot water. As a result, the presence or absence of creases in the protective film-equipped sealing member A (specifically, sealing member) that has been subjected to the dehydration step was visually checked. As a result, no creases were observed in the protective film-equipped sealing member A.

In Example 1, a device base B in which an anode layer, an organic EL unit, and a cathode layer were provided in this order on a substrate was further manufactured. The organic EL unit had a multilayer structure in which, from the anode layer side, a hole injection layer, a hole transport layer, a light emitting layer, an electron transport layer, and an electron injection layer were layered.

An organic EL device was manufactured in such a manner that a sealing member obtained by removing the protective film from the protective film-equipped sealing member A that has been subjected to the dehydration step was bonded to the device base B. No air bubbles or creases were observed in the bonding surface between the sealing member and the device base B.

### [Comparative Example 1]

In Comparative Example 1, a protective film-equipped sealing member A having the same configuration as in Example 1 was prepared. In Comparative Example 1, the dehydration step was performed under the same conditions as in Example 1 except that the temperature of the roll surface of the conveyor roll (heating roll) in contact with the protective film-equipped sealing member A was heated to 50°C. As a result, in Comparative Example 1, creases continuously extending in the conveyance direction were found in the protective film-equipped sealing member A (specifically, sealing member) that has been subjected to the dehydration step.

Also in Comparative Example 1, a device base B having the same configuration as Example 1 was fabricated. Afterwards, an organic EL device was manufactured in such a manner that a sealing member obtained by removing the protective film from the protective film-equipped sealing member A that has been subjected to the dehydration step of Comparative Example 1 was bonded to the device base B. Air bubbles and creases were observed in the bonding surface between the sealing member and the device base B.

### [Example 2]

In Example 2, a protective film-equipped sealing member A having the same configuration as in Example 1 was prepared, and a dehydration step was performed under the same conditions as in Example 1 and a slow cooling step was performed continuously after the dehydration step. To be specific, in a situation where the protective film-equipped sealing member A is not heated by the infrared heater, after the roll surface is brought into contact with heating rolls heated to 80°C, the protective film-equipped sealing member A is conveyed while being brought into contact with a heating roll whose roll surface is heated to 70°C and then a heating roll whose roll surface is heated to 60°C, whereby the temperature of the protective film-equipped sealing member A (specifically, the temperature of the PET film) was slowly cooled to 60°C. After the temperature of the protective film-equipped sealing member A reached 60°C, it was brought into contact with a conveyor roll whose roll surface had a temperature of 23°C. As a result, no creases were found in the protective film-equipped sealing member A (specifically, sealing member).

Also in Example 2, after the device base B having the same configuration as in Example 1 was fabricated, an organic EL device was manufactured in such a manner that a sealing member obtained by removing the protective film from the protective film-equipped sealing member A that has been subjected to the slow cooling step was bonded to the device base B. No air bubbles or creases were observed in the bonding surface between the sealing member and the device base B.

The comparison between the results of Example 1 and Comparative Example 1 proved that, since the temperature of the roll surface of the conveyor roll in contact with the protective film-equipped sealing member A heated with the infrared heater was higher than or equal to the glass transition temperature (69°C) of the PET film (corresponding to the resin film 23) of the protective film-equipped sealing member A, creases in the protective film-equipped sealing member A that has been subjected to the dehydration step could be suppressed. The results of Example 2 proved that creases did not occur in the PET film of the protective film-equipped sealing member A even when the slow cooling step was performed continuously after the dehydration step.

The various embodiments of the present invention have been described above. However, the present invention should not be limited by these illustrated various embodiments, and should be defined by the scope of the claims and include equivalents of the claims and all modifications in the scope.

Although the above description has been made taking the case where the protective film-equipped sealing member has a strip shape as an example, the protective film-equipped sealing member may have a sheet shape. Similarly, the device base (or the substrate of the device base) may have a sheet shape.

The step of preparing the protective film-equipped sealing member including the unwinding step and the winding step has been explained. However, the step of preparing the protective film-equipped sealing member does not necessarily include at least one of the unwinding step and the winding step. For example, without the unwinding step, the sealing member bonding step may be continuously performed after the dehydration step while the heated and dehydrated protective film-equipped sealing member is continuously conveyed.

The organic EL device manufacturing method described so far may include, before the dehydration step, a preheating step in which the protective film-equipped sealing member is gradually heated until the protective film-equipped sealing member becomes higher than or equal to the glass transition temperature of the resin layer. In this case, a dehydration step is performed subsequently to the preheating step. In the mode including the preheating step, creases are less likely to occur in the protective film-equipped sealing member during a temperature rising process. In the preheating step, for example, the protective film-equipped sealing member is conveyed with a plurality of preheating rolls. The temperature of the roll surface of the plurality of preheating rolls may be set so that it gradually increases from a temperature less than the glass transition temperature of the resin layer to a temperature higher than or equal to the glass transition temperature, from the upstream preheating roll toward the downstream preheating roll. In this case, it is possible to prevent rapid cooling of the resin layer caused by the contact of the resin layer with a roll during heating. Accordingly, the protective film-equipped sealing member can be gradually and efficiently heated while preventing creases caused by the rapid cooling. In the plurality of preheating rolls set to be gradually increased, the temperature of the roll surface of each preheating roll may be set according to, for example, the conveyance distance, the conveyance speed, and the like in the preheating step. For example, when the conveyance distance in the preheating step is long, the difference between the roll surface temperatures of the preheating rolls adjacent to each other in the conveyance direction of the protective film-equipped sealing member is set large, and at a high conveyance speed, the difference between the roll surface temperatures of the heating rolls adjacent to each other in the conveyance direction of the protective film-equipped sealing member may be set small. The conveyance distance in the preheating step is a distance at which the temperature of the resin layer become higher than or equal to the glass transition temperature, and may be calculated in advance by a simulation or may be a distance based on an actual experimental result. When the number of the preheating rolls used in the preheating step is three, the temperature of the roll surface of the most upstream preheating roll in the preheating step may be set to room temperature (for example, 22°C to 30°C), the temperature of the roll surface of the preheating roll in the middle may be set to a temperature between the room temperature and the glass transition temperature, and the temperature of the roll surface of the most downstream preheating roll may be set higher than or equal to the glass transition temperature. The most downstream preheating roll and the most upstream heating roll R1 (see Figure 4) in the dehydration step may be the same roll. In the preheating step, the protective film-equipped sealing member may be gradually heated during emission of infrared rays.

The organic EL device manufactured by the organic EL device manufacturing method is not necessarily in the mode in which light is emitted from the substrate side, and is also applicable to an organic EL device in which light is emitted from the side opposite to the substrate. Although the mode in which the first electrode and second electrode of the device base are the anode and the cathode, respectively, has been described, the first electrode may be the cathode and the second electrode may be the anode. The present invention is also applicable to organic electronic devices other than organic EL devices, for example, organic solar cells, organic photodetectors, and organic transistors.

### Reference Signs List

10: Protective film-equipped sealing member, 20: Sealing member, 21: sealing base, 22: Adhesive layer, 23: Resin film (resin layer), 30: Protective film, 40: Device base, 41: Substrate, 42: Anode (first electrode), 43: Organic EL unit (device functional part), 44: Cathode (second electrode), 54: Infrared irradiator, R1: Heating roll

## Claims

1. An organic electronic device manufacturing method comprising:
a device base forming step of forming a device base in which a first electrode, a device functional part including an organic layer, and a second electrode are provided in this order on a substrate;
a dehydration step of heating and dehydrating a protective film-equipped sealing member, in which a protective film is laminated, via an adhesive layer, on a sealing member having a sealing base, the adhesive layer laminated on an one surface of the sealing base, and a resin layer laminated on an other surface of the sealing base, while the protective film-equipped sealing member is conveyed using at least one roll; and
a sealing member bonding step of removing the protective film from the protective film-equipped sealing member subjected to the dehydration step, and then bonding the sealing member to the device base through the adhesive layer, wherein
in the dehydration step, a temperature of a roll surface of the roll in contact with the protective film-equipped sealing member being conveyed is higher than or equal to a glass transition temperature of the resin layer.

2. The organic electronic device manufacturing method according to Claim 1, comprising a slow cooling step of, after the dehydration step, slowly cooling the protective film-equipped sealing member until the protective film-equipped sealing member becomes below a glass transition temperature of the resin layer.

3. The organic electronic device manufacturing method according to Claim 2, wherein
in the slow cooling step, the protective film-equipped sealing member is conveyed with a plurality of rolls; and
a temperature of a roll surface of each of the plurality of rolls in the slow cooling step is set in such a way as to gradually decrease from a temperature higher than or equal to the glass transition temperature of the resin layer to a temperature lower than the glass transition temperature of the resin layer, from an upstream roll to a downstream roll.

4. The organic electronic device manufacturing method according to any one of Claims 1 to 3, comprising a preheating step of, before the dehydration step, gradually heating the protective film-equipped sealing member until the protective film-equipped sealing member becomes higher than or equal to a glass transition temperature of the resin layer.

5. The organic electronic device manufacturing method according to Claim 4, wherein
in the preheating step, the protective film-equipped sealing member is conveyed with a plurality of preheating rolls; and
a temperature of a roll surface of each of the plurality of preheating rolls in the preheating step is set in such a way as to gradually increase from a temperature lower than the glass transition temperature of the resin layer to a temperature higher than or equal to the glass transition temperature of the resin layer, from an upstream preheating roll to a downstream preheating roll.
